# EUROPEAN PATENT APPLICATION

(11) **EP 4 819 178 A1**
(43) Date of publication of application: **07.10.2026**
(21) Application number: 25167359.6
(22) Date of filing: 31.03.2025
(51) Int. Cl.: H01H 1/14, H01H 1/58, H01H 13/52, H05K 1/11, H05K 1/18, H01H 1/40, H01H 1/20

(54) **SYSTEM COMPRISING A CIRCUIT BOARD AND A LATERAL BUTTON**

(71) Applicant: Jabil Inc., St. Petersburg, Florida 33716 (US)
(72) Inventor: Olbert, Felix, 1230 Wien (AT); Benes, Harald, 1230 Wien (AT); Reinprecht, Markus, 1230 Wien (AT)
(74) Representative: Schwarz & Partner Patentanwälte GmbH

(57) **Abstract**

The invention relates to a system comprising a circuit board (1) and a movable button (5), wherein the circuit board (1) has a first face (2), a second face (3), and a plurality of edge faces (4), and comprises a first location and a second location, which are each coated with an electrically conductive coating. The button (5) comprises an electrically conductive material (5a) and is movable towards the circuit board (1), such that it contacts both the first location and the second location, thereby creating an electrical contact between the first location and the second location. The first location is located on a first edge face (4a), the second location is located on a second edge face (4b), wherein an angle enclosed between outward normal vectors of the first edge face (4a) and the second edge face (4b) is within the range of 0° to 90°, and wherein the button (5) has a complementary profile forming a mating surface with the first edge face (4a) and the second edge face (4b).

## Description

### Field of the invention

The present invention relates to a system comprising a circuit board and a movable button according to the preamble of claim 1.

### Background of the invention

Circuit boards, for instance printed circuit boards (PCBs), serve as fundamental components in modern electronic systems, providing a structured platform for the integration of electrical circuits. They consist of a non-conductive substrate, commonly composed of epoxy resin, onto which conductive pathways, or traces, are layered using copper. These traces enable electrical connectivity between components without the need for extensive manual wiring, facilitating compact and efficient circuit designs. PCBs are widely utilized in consumer electronics and embedded systems, due to their reliability and scalability in manufacturing.

Among the various elements that can be implemented on a PCB, electrical contacts play a important role in facilitating user interaction with electronic devices. These contacts are typically exposed conductive pads or traces on the PCB surface that, when connected, complete an electrical circuit. A common implementation of such a mechanism involves buttons or switches that temporarily establish conductivity between designated contact points. When a button is pressed, it physically bridges the gap between these contacts, thereby enabling the flow of current and signaling an input to the circuit.

One disadvantage of such PCB-button systems in the prior art is that the actuation force is typically applied perpendicular to the plane of the PCB. This presents a challenge when the product's design requires a button to be pressed from the side, as it necessitates the use of a secondary PCB mounted perpendicularly to the primary board. Such an arrangement increases material and assembly costs while also introducing additional complexity to the overall system. An alternative approach to addressing this limitation involves the use of PCB-mounted micro switches, which incorporate an integrated button mechanism. However, these components are often bulky, adding to space constraints and potentially limiting design flexibility.

### Summary of the invention

It is the object of the present invention to provide a system which alleviates or eliminates at least individual disadvantages of the prior art.

This object is achieved by providing a system as defined in claim 1. Preferred embodiments of the invention are defined in the dependent claims, the description, and the drawings.

### Detailed description of the invention

According to the invention, a system is provided, comprising a circuit board and a movable button, wherein the circuit board has a surface defined by a first face, a second face, and a plurality of edge faces, wherein the edge faces connect a first perimeter of the first face to a second perimeter of the second face, wherein the surface of the circuit board comprises a first location and a second location, wherein the first location and the second location are each coated with an electrically conductive coating, wherein the button comprises an electrically conductive material, wherein the button is movable towards the circuit board, such that the electrically conductive material contacts both the first location and the second location, thereby creating an electrical contact between the first location and the second location. The first location is located on a first edge face, the second location is located on a second edge face, wherein an angle enclosed between an outward normal vector of the first edge face and an outward normal vector of the second edge face is within the range of 0° to 90°, and wherein the button has a complementary profile forming a mating surface with the first edge face and the second edge face.

As used herein, the term "circuit board" generally refers to a flat, insulating substrate that provides mechanical support and electrical connections for electronic components. It comprises conductive pathways, typically made of copper, that are etched or printed onto the surface or within the layers of the board. These pathways facilitate the transmission of electrical signals between components. In other words, a circuit board refers to any board used for electronic circuits and can encompass a variety of embodiments, including wire-wrapped boards, point-to-point soldered boards, breadboards, and printed circuit boards (PCBs). As used herein, the term "printed circuit board" (PCB) refers to a type of circuit board that has conductive tracks etched, printed, or otherwise embedded onto an insulating substrate. The term "circuit board" further encompasses variations including single-layer, double-layer, and multi-layer boards, which differ in the number of conductive layers they contain. Additionally, specialized types such as flexible circuit boards, which are designed to bend without breaking, and rigid-flex boards, which combine both rigid and flexible sections, fall under this term.

As used herein, the terms "first face" and "second face" refer to the two primary, opposing surfaces of a circuit board. The first face and the second face are generally congruent, meaning they share the same shape and dimensions. The perimeter of the first face is connected to the perimeter of the second face by a plurality of edge faces, which form the sides of the board. In the simplest case, where the first and second faces are rectangular, the circuit board has four edge faces, each extending between corresponding edges of the two main faces.

As used herein, the term "outward normal vector" refers to a vector that is perpendicular to a given surface and oriented outward from the enclosed volume. For the purposes of this disclosure, the magnitude of this vector is not significant and may be assumed to be a unit vector. In the context of the present disclosure, outward normal vectors are primarily considered in relation to edge faces. Minor surface irregularities along an edge face should be disregarded, the calculation of the outward normal vector should be based on an idealized, smooth edge face.

As used herein, the term "angle enclosed" between a first vector and a second vector refers to the smallest angle formed when the vectors are positioned such that their initial points coincide. This angle is measured within a plane containing both vectors and can be visualized as the angle between two lines extending from a common origin in the directions of the respective vectors. **In** other words, this angle quantifies the spatial orientation difference between the two vectors.

As used herein, the term "complementary profile" refers to a shape or contour of a component that is specifically designed to correspond with the shape of another component. This implies that when the two components are aligned and assembled, their surfaces fit together, ideally with minimal gaps or spaces, ensuring a precise connection. The term "mating surface" refers to a specific area or face of a mechanical component that directly contacts another component when the two are joined. In the context of the present disclosure, the button has a complimentary profile in order to form a mating surface with the first edge face and the second edge face.

The system according to the invention offers several advantages over known systems in the prior art. First of all, the system according to the invention offers greater flexibility, as the positioning of the button can be chosen more flexibly, enabling new designs especially in confined spaces. The system according to the invention also offers significant cost savings, as the need for an additional circuit boards is eliminated, reducing material and assembly costs. The system according to the invention also offers a simplified design, as it does not require any additional cables or plug connections, which greatly simplifies the assembly process. The system according to the invention furthermore offers a very durable configuration of circuit board and button, as the system minimizes wear and damage to the conductive layer of the circuit board.

In a preferred embodiment, the first edge face and the second edge face share a common plane. This embodiment offers a simple design, wherein the angle enclosed between an outward normal vector of the first edge face and an outward normal vector of the second edge face is essentially equal to 0°. As a consequence, the complimentary profile of the button is essentially a flat profile and the mating surface is also essentially flat.

In a preferred embodiment, the system further comprises a button carrier, wherein the button carrier is, preferably detachably, mounted on the circuit board and comprises a button guide for guiding the button. If the button guide is mounted on the circuit board, this embodiment offers a button guide for the button, thus ensuring precise placement and positioning of the button along its movable travel distance. In other words, by using the button guide, a user can reliably electrically connect the first location to the second location in order to form a closed circuit. When the button carrier is mounted on the circuit board, the button carrier essentially cannot move in relation to the circuit board. However, it is preferred if the connection between the button carrier and the circuit board is a detachable connection. As such, the button carrier may easily be replaced in case of inspection or repairs.

In a preferred embodiment, the button carrier and/or the button comprise(s) means for limiting a travel distance of the button. In this embodiment, even if a large force is applied on the button when it is pushed towards the circuit board, the means for limiting a travel distance of the button prevent the button to travel too far towards the circuit board. This helps prevent damage to the button, which may be composed of a softer material compared to the circuit board. This also helps prevent damage to the graphite layer(s) of the circuit board.

The means for limiting a travel distance can be realized in a plurality of different ways, two examples of which will be discussed now. It should be understood that a person skilled in the art is of course able to implement different ways of limiting a travel distance of the button, which may differ from the examples discussed herein.

A first exemplary way to realize a means for limiting the travel distance of the button may be a protrusion on the button, extending outwards in a radial direction. While referring to the direction of the button moving towards the circuit board, the protrusion is located upstream of the button carrier. When the button is pushed towards the circuit board, the protrusion moves towards the button carrier. Once the protrusion contacts the button carrier, the button cannot move any further.

Another exemplary way to realize a means for limiting the travel distance of the button may be a nose located on the button carrier, such that when the button moves towards the circuit board, the button moves toward the nose. Once the button abuts the nose, the button cannot move any further in that direction.

In a preferred embodiment, the button carrier has a through-hole which forms the button guide, wherein the shape of the through-hole substantially matches a cross-section of the button. The button carrier includes a through-hole that serves as a button guide, where the shape of the through-hole substantially corresponds to the cross-sectional shape of the button. This design provides a straightforward and effective means of guiding the button while ensuring proper alignment and movement within the carrier. For example, if the button has a cylindrical shape, the through-hole is correspondingly circular. Similarly, if the button has a cubic shape, the through-hole takes the form of a square. This embodiment facilitates smooth operation and stability while minimizing unnecessary movement or misalignment of the button within the carrier.

In a preferred embodiment, the button comprises a groove and the electrically conductive material is located on the mating surface inside the groove, wherein a width of the groove corresponds essentially to a thickness of the circuit board. In this embodiment, the groove on the button is designed to receive the circuit board. This further helps to reduce a misalignment of the button with regards to the circuit board.

In a preferred embodiment, the first edge face and the second edge face smoothly connect the first face of the circuit board to the second face of the circuit board. The first edge face and second edge face provide a smooth, continuous transition between the first face and second face of the circuit board. This means there are no abrupt changes in direction at the junctions where the edge faces meet the first face or the second face. Instead, the transition is rounded, ensuring a gradual change in slope. The curvature at these transitions is defined by a radius of curvature that is at most half the thickness of the circuit board, preferably less than 50% of that value. This design promotes a seamless contour by reducing sharp edges.

In a preferred embodiment, the electrically conductive coating is made of gold, copper, tin, silver, or a combination thereof. Gold, copper, tin, and silver are employed as coating materials for circuit boards due to their excellent electrical conductivity and corrosion resistance. Gold provides good oxidation resistance, ensuring stable long-term performance. Copper offers high electrical conductivity and thermal dissipation at relatively low cost. Tin is valued for its affordability, good solderability, and adequate protection against corrosion. Silver combines high electrical conductivity with good thermal properties.

In a preferred embodiment, the electrically conductive material is made of graphite, gold, copper, tin, silver, or a combination thereof. Graphite, gold, copper, tin, and silver are advantageous as electrically conductive coatings for the button due to their reliable electrical performance and durability. Graphite provides consistent electrical conductivity, wear resistance, and low friction, which makes it suitable for buttons requiring frequent pressing. Gold, while more expensive, offers exceptional corrosion resistance and maintains stable conductivity over time. Copper is cost-effective, highly conductive, and efficient at heat dissipation. Tin is valued for its affordability, good solderability, and adequate protection against corrosion. Silver combines high electrical conductivity with good thermal properties.

In a preferred embodiment, the button is made of the electrically conductive material, or wherein the button is at least partially coated with the electrically conductive material. In the case where the button itself is made entirely of an electrically conductive material, benefits include consistent electrical conductivity throughout the button, improved durability due to the absence of coatings that could wear off, and reliable long-term electrical performance. This design ensures that electrical signals can pass directly through the button without intermediate layers, providing good responsiveness and potentially simplifying the button's design. Conversely, when the button is at least partially coated with an electrically conductive material, benefits include the ability to use more cost-effective or structurally favorable base materials beneath the electrically conductive coating, reduced material costs, and greater design flexibility. Such coatings can also allow selective enhancement of electrical conductivity precisely where it is most needed, while simultaneously providing corrosion resistance, wear protection, and improved electrical contact stability without the expense or complexity of using conductive materials throughout the entire button structure.

In a preferred embodiment, the circuit board further comprises a third location coated with the electrically conductive coating and located on a third edge face, wherein an angle enclosed between an outward normal vector of the first edge face and an outward normal vector of the third edge face is within the range of 0° to 90°, wherein an angle enclosed between an outward normal vector of the second edge face and an outward normal vector of the third edge face is within the range of 0° to 90°, and wherein the button has a complementary profile forming a mating surface with the first edge face, the second edge face and the third edge face, wherein the button comprises an electrically insulating material, which is located along the mating surface of the button such that when the electrically conductive material contacts the first location and the second location, the electrically insulating material contacts the third location.

In this embodiment, when the button is pushed towards the circuit board, it contacts three locations: the first location, the second location and the third location. However, not all of these locations will be in electrical contact, as the button has an electrically insulating material touching the third location. By varying the location of the electrically insulating material on the mating surface of the button, one and the same circuit board can be employed to realize different electrical circuits. For example, the circuit board can have three locations next to each other, which will be labelled A, B and C in the following. If the button does not comprise an electrically insulating material on its mating surface, then A, B and C will be in electric contact, once the button abuts the circuit board. However, by strategically positioning the electrically insulating material on the mating surface of the button, the choice of the button dictates whether only A and B, or A and C, or B and C will be in electrical contact.

In a preferred embodiment, the electrically conductive coating is an L-shaped plate, wherein a first L-shaped plate coats the first location and extends onto the first face and a second L-shaped plate coats the second location and extends onto the first face. This embodiment offers a simple manufacturing process, as the electrically conductive coating can be applied in a late stage of the manufacturing process of the circuit board. For instance, the circuit board can be manufactured to only comprise an electrically conductive coating on its first face. By applying (i.e., soldering, mechanical fastening using screws or rivets or clips, conductive adhesives such as epoxy resin, or by a mechanical interlocking method such as a snap fit) the L-shaped plate onto the circuit board, the first location and the second location will receive an electrically conductive coating.

According to another aspect of the invention, a use of the system according to the invention is provided in a method for creating an electrical contact between a circuit board and a button, the method comprising the following steps:
- providing the system, comprising the circuit board and the movable button, according to any one of the previous embodiments,
- moving the button in a direction orthogonal to a normal vector of the first face of the circuit board towards the circuit board, thereby bringing the electrically conductive material into contact with the first location and the second location, and if applicable, bringing the electrically insulating material into contact with the third location. It will be obvious to a person skilled in the art that this method provides the same benefits as have been discussed above.

### Brief description of the drawings

The present invention will now be described by way of illustrative examples with reference to the accompanying drawings, in which:
Fig. 1 shows a schematic illustration of a circuit board according to an embodiment of the invention,
Fig. 2a shows a cross section of a circuit board, wherein an edge face smoothly connects the first face and the second face of the circuit board according to an embodiment of the invention,
Fig. 2b shows a cross section of a circuit board, wherein an edge face smoothly connects the first face and the second face of the circuit board according to another embodiment of the invention,
Fig. 2c shows a cross section of a circuit board, wherein an edge face smoothly connects the first face and the second face of the circuit board according to yet another embodiment of the invention,
Fig. 3 shows a cross section of a circuit board according to an embodiment of the invention wherein the electrically conductive coating is an L-shaped plate,
Fig. 4 shows a button carrier with two buttons according to an embodiment of the invention,
Fig. 5 shows a cross section of a button carrier according to another embodiment of the invention,
Fig. 6a shows a front view of a button according to an embodiment of the invention, wherein the button comprises a groove and an electrically conductive material is located inside the groove,
Fig. 6b shows a front view of a button according to another embodiment of the invention, wherein the button comprises a groove and both an electrically conductive material as well as an electrically insulating material is located inside the groove,
Fig. 7a shows a schematic illustration of a system according to an embodiment of the invention, wherein an angle enclosed between an outward normal vector of a first edge face and an outward normal vector of a second edge face is approximately 0°,
Fig. 7b shows a schematic illustration of a system according to an embodiment of the invention, wherein an angle enclosed between an outward normal vector of a first edge face and an outward normal vector of a second edge face is approximately 0°,
Fig. 8a shows a schematic illustration of a system according to an embodiment of the invention, wherein an angle enclosed between an outward normal vector of a first edge face and an outward normal vector of a second edge face is approximately 90°,
Fig. 8b shows a schematic illustration of a system according to an embodiment of the invention, wherein an angle enclosed between an outward normal vector of a first edge face and an outward normal vector of a second edge face is approximately 90°,
Fig. 9 shows a schematic illustration of a system according to an embodiment of the invention, wherein an angle enclosed between an outward normal vector of a first edge face and an outward normal vector of a second edge face is approximately 45°,
Fig. 10 shows a schematic illustration of a system not according to the invention, wherein an angle enclosed between an outward normal vector of a first edge face and an outward normal vector of a second edge face is approximately 180°,

### Detailed description of the drawings

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Processes, elements, and techniques not considered necessary to those having ordinary skill in the art for a complete understanding of the aspects and features of the present invention may not be described. In the drawings, the relative sizes of elements, layers, and regions may be exaggerated for clarity. The below-described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

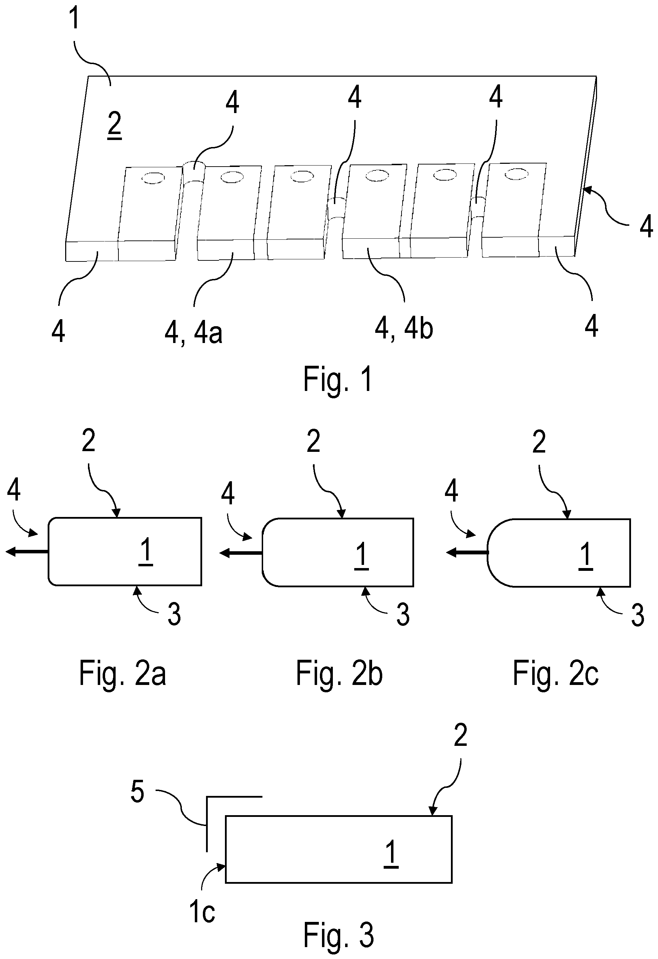

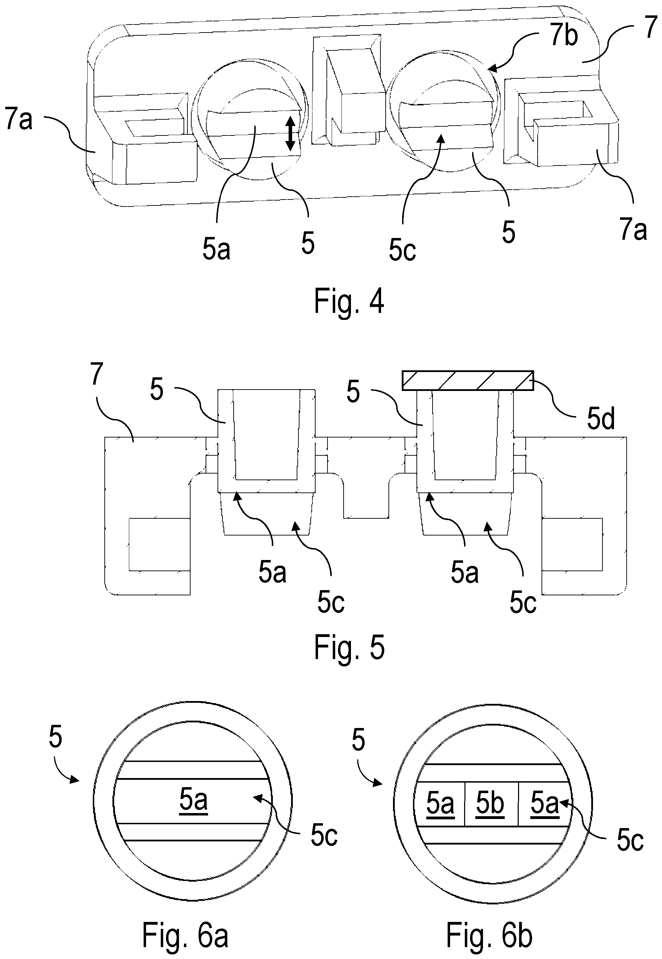

Fig. 1 shows a schematic illustration of a circuit board according to an embodiment of the invention. The circuit board 1 has a surface defined by a first face 2, a second face 3 (not visible due to the perspective drawing of the circuit board 1), and a plurality of edge faces 4, wherein the edge faces 4 connect a first perimeter of the first face 2 to a second perimeter of the second face 3. Many (although for the sake of simplicity not all) edge faces 4 are indicated in Fig. 1 with the reference sign "4". In the embodiment shown in Fig. 1, the first face 2 and the second face 3 are congruent, meaning they share the same shape and dimensions. The system according to the invention further comprises a button 5, which is not shown in Fig. 1 (the button will be discussed in detail with reference to Figs. 4, 5, 6a and 6b).

A first location and a second location are each coated with an electrically conductive coating made of gold. This coating can however also be made of copper, tin, silver, or a combination of these materials.

According to the invention, the first location is located on a first edge face 4a and the second location is located on a second edge face 4b. In the embodiment shown in Fig. 1, an angle enclosed between an outward normal vector of the first edge face 4a (corresponding to the first location) and an outward normal vector of the second edge face 4b (corresponding to the second location) is approximately 0°. More precisely, the first edge face 4a and the second edge face 4b share a common plane. In order to contact the first edge face 4a and the second edge face 4b, the button 5 has a complementary profile forming a mating surface with the first edge face 4a and the second edge face 4b.

Fig. 2a shows a cross section of a circuit board 1, wherein an edge face 4 smoothly connects the first face 2 and the second face 3 of the circuit board 1, Fig. 2b shows a cross section of a circuit board 1, wherein an edge face smoothly connects the first face 2 and the second face 3 of the circuit board 1, and Fig. 2c shows a cross section of a circuit board 1, wherein an edge face 4 smoothly connects the first face 2 and the second face 3 of the circuit board 1. The edge face 4 provides a smooth, continuous transition between the first face 2 and second face 3 of the circuit board 1. This means there are no abrupt changes in direction at the junctions where the edge face 4 meets the first face 2 or the second face 3. Instead, the transition is rounded, ensuring a gradual change in slope. The curvature at these transitions is defined by a radius of curvature, wherein in the order of Fig. 2a, 2b, 2c, the radius of curvature is increasing.

Irrespective of the radius of curvature, the direction of the outward normal vector does not change. In each of Figs. 2a, 2b and 2c, the outward normal vector is drawn as a solid black arrow. Even though the edge face 4 features a rounded transition towards the first face 2 and the second face 3, a person skilled in the art will understand that the outward normal vector is not to be calculated at this transition. Instead, the outward normal vector is to be calculated such that it yields the same result in case the radius of curvature was zero.

Fig. 3 shows a cross section of a circuit board 1 according to an embodiment of the invention wherein the electrically conductive coating is an L-shaped plate 6. By applying the L-shaped plate 6 onto the circuit board 1, the first location (and the second location, which is not shown) on the first edge face 4a will receive an electrically conductive coating.

Fig. 4 shows a button carrier 7 with two buttons 5 in a system according to an embodiment of the invention. Each button 5 comprises an electrically conductive material 5a, such that when the button 5 is moved towards the circuit board 1, the electrically conductive material 5a contacts both the first location (on the first edge face 4a) and the second location (on the second edge face 4b), thereby creating an electrical contact between the first location and the second location. The electrically conductive material 5a in this embodiment is graphite. It is however also possible that the electrically conductive material 5a is gold, copper, tin, silver, or a combination of these materials. In further embodiments, the button can comprise an electrically insulating material 5b, which will be discussed in more detail with reference to Fig. 6b.

In this embodiment, the electrically conductive material 5a is applied to the mating surface of the button 5 as a coating. In another embodiment, the button 5 may be composed of the electrically conductive material 5a in its entirety.

In the embodiment shown in Fig. 4, each button 5 comprises a groove 5c and the electrically conductive material 5a is located on the mating surface of the button 5 inside the groove 5c, wherein a width of the groove 5c (indicated by a double arrow near the left-hand button 5 in Fig. 4) corresponds essentially to the thickness of the circuit board 1. The groove 5c on each button 5 is designed to receive the circuit board 1. This helps to reduce any misalignment of the button 5 with regards to the circuit board 1. Since the circuit board 1 is received within the groove 5c, it is particularly preferable to combine this embodiment with one of the embodiments shown in any one of Figs. 2a, 2b or 2c. In other words, such that the rounded corners of the circuit board 1 facilitate a smooth entry of the circuit board 1 into the groove 5c.

The button carrier 7 can be mounted onto the circuit board 1. In order to facilitate this, the button carrier 7 has two arms 7a, which engage with suitable formed parts of the circuit board 1. It is particularly preferred if this connection between the button carrier 7 and the circuit board 1 is a detachable connection.

The button carrier 7 further comprises a button guide for guiding each of the buttons 5 shown in Fig. 4. In this embodiment, the button guide is formed by a through-hole 7b, wherein the shape of the through-hole 7b substantially matches a cross-section of the guided button 5. More specifically, the button guide is formed by a circular through-hole 7b, which substantially matches the circular cross-section of the button 5.

Fig. 5 shows a cross section of a button carrier 7. The button carrier 7 shown in Fig. 5 is substantially the same button carrier 7 as shown in Fig. 4, so reference is made to the description of Fig. 4. In the following, only those features of the button carrier 7 will be discussed that differ from the embodiment shown in Fig. 4.

The button carrier 7 shown in Fig. 5 comprises two buttons 5, wherein the right-hand side button 5 features means for limiting a travel distance of the button. This is realized as a protrusion 5d on the button 5, extending outwards in a radial direction. While referring to the direction of the button 5 moving towards the circuit board 1 (in Fig. 5: the downward direction), the protrusion 5d is located upstream of the button carrier 7 (in Fig. 5: above the button carrier 7). When the button 5 is pushed towards the circuit board 1, the protrusion 5d moves towards the button carrier 7. Once the protrusion 5d contacts the button carrier 7, the button 5 cannot move any further.

Fig. 6a shows a front view of a button 5 according to an embodiment of the invention, wherein the button 5 comprises a groove 5c and an electrically conductive material 5a is located inside the groove 5c. In this embodiment, the entire mating surface inside the groove 5c is coated with the electrically conductive material 5a. Hence, when the button 5 moves towards the circuit board 1, the electrically conductive material 5a contacts both the first location and the second location, thereby creating an electrical contact between the first location and the second location.

Fig. 6b shows a front view of a button 5 according to another embodiment of the invention, wherein the button 5 comprises a groove 5c and both an electrically conductive material 5a as well as an electrically insulating material 5b are located inside the groove 5c. In this embodiment, the electrically insulating material 5b is realized as a coating on top of the electrically conductive material 5a. Hence, even if the mating surface of the button 5 contacts the first location, the second location and the third location, the electrically conductive material 5a only contacts the first location and the second location, and the electrically insulating material 5b contacts the third location. Since the electrically insulating material 5b is realized as a coating on top of the electrically conductive material 5a, the button 5 can still create an electrical contact between the first location and the second location.

Of course, different arrangements of the electrically insulating material 5b on the mating surface of the button 5 are possible. For instance, the electrically insulating material 5b can be positioned on a different position along the mating surface of the button 5. Additionally, it is possible that the button 5 comprises another electrically insulating material 5b at a different position along the mating surface of the button 5.

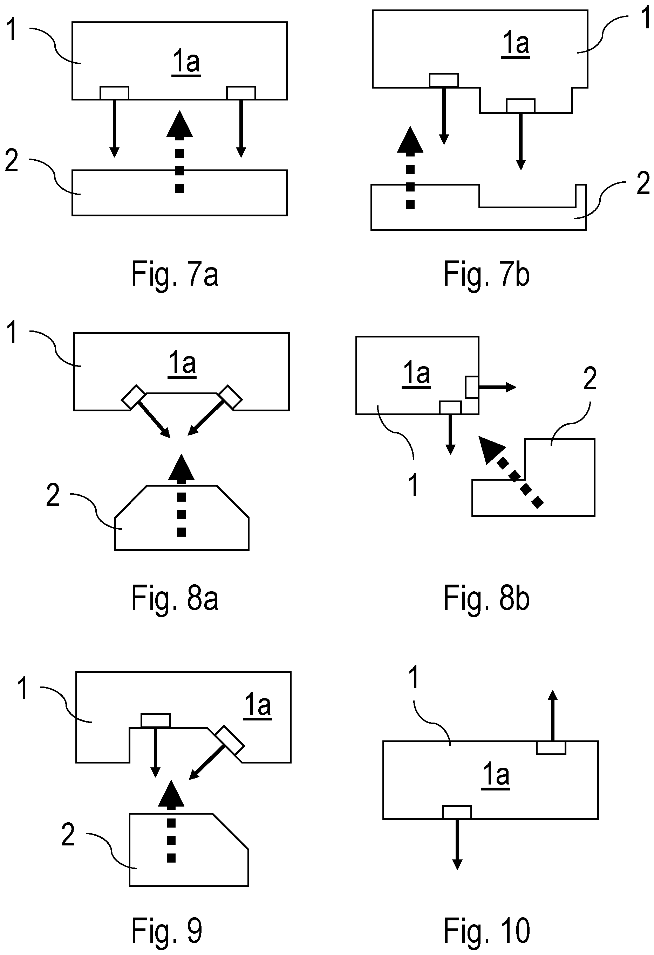

Fig. 7a shows a schematic illustration of a system according to an embodiment of the invention, comprising a circuit board 1 and a button 5, wherein an angle enclosed between an outward normal vector of a first edge face 4a and an outward normal vector of a second edge face 4b is approximately 0°. In this schematic drawing, the first location and the second location are indicated by small rectangles in order not to obfuscate the drawing with too many reference signs. Fig. 7a shows a circuit board 1 and a button 5, wherein the direction of movement of the movable button 5 is indicated by a dashed thick arrow. In this embodiment, the first edge face 4a and the second edge face 4b share a common plane and the mating surface of the button 5 is hence also a flat plane.

Fig. 7b shows a schematic illustration of a system according to an embodiment of the invention, comprising a circuit board 1 and a button 5, wherein an angle enclosed between an outward normal vector of a first edge face 4a and an outward normal vector of a second edge face 4b is approximately 0°. In this schematic drawing, the first location and the second location are indicated by small rectangles in order not to obfuscate the drawing with too many reference signs. Fig. 7b shows a circuit board 1 and a button 5, wherein the direction of movement of the movable button 5 is indicated by a dashed thick arrow. In this embodiment, the first edge face 4a and the second edge face 4b do not share a common plane, instead they are offset by a certain amount. The corresponding mating surface of the button 5 comprises two parallel planes, which also do not share a common plane.

Fig. 8a shows a schematic illustration of a system according to an embodiment of the invention, comprising a circuit board 1 and a button 5, wherein an angle enclosed between an outward normal vector of a first edge face 4a and an outward normal vector of a second edge face 4b is approximately 90°. In this schematic drawing, the first location and the second location are indicated by small rectangles in order not to obfuscate the drawing with too many reference signs. Fig. 8a shows a circuit board 1 and a button 5, wherein the direction of movement of the movable button 5 is indicated by a dashed thick arrow. In this embodiment, the mating surface of the button 5 comprises three planes.

Fig. 8b shows a schematic illustration of a system according to an embodiment of the invention, comprising a circuit board 1 and a button 5, wherein an angle enclosed between an outward normal vector of a first edge face 4a and an outward normal vector of a second edge face 4b is approximately 90°. In this schematic drawing, the first location and the second location are indicated by small rectangles in order not to obfuscate the drawing with too many reference signs. Fig. 8b shows a circuit board 1 and a button 5, wherein the direction of movement of the movable button 5 is indicated by a dashed thick arrow. In this embodiment, the button 5 moves in a diagonal direction due to the particular positioning of the first location and the second location. The mating surface of the button 5 comprises two planes.

Fig. 9 shows a schematic illustration of a system according to an embodiment of the invention, comprising a circuit board 1 and a button 5, wherein an angle enclosed between an outward normal vector of a first edge face 4a and an outward normal vector of a second edge face 4b is approximately 45°. In this schematic drawing, the first location and the second location are indicated by small rectangles in order not to obfuscate the drawing with too many reference signs. Fig. 9 shows a circuit board 1 and a button 5, wherein the direction of movement of the movable button 5 is indicated by a dashed thick arrow. In this embodiment, the mating surface of the button 5 comprises two planes.

Fig. 10 shows a schematic illustration of a system not according to the invention, wherein an angle enclosed between an outward normal vector of a first edge face and an outward normal vector of a second edge face is approximately 180°. This embodiment of a circuit board 1 is not encompassed by the present invention and merely serves as an example of an embodiment, wherein the angle enclosed between an outward normal vector of a first edge face and an outward normal vector of a second edge face is outside the claimed region.

It can be seen that various features are grouped together in a single embodiment for the purpose of streamlining the disclosure of the invention. This method of disclosure is not to be interpreted as reflecting an intention that the claimed embodiments require more features than are expressly recited in each claim. Rather, as the claims reflect, the inventive subject matter lies in less than all features of a single disclosed embodiment.

## Claims

1. A system, comprising a circuit board (1) and a movable button (5),
wherein the circuit board (1) has a surface defined by a first face (2), a second face (3), and a plurality of edge faces (4), wherein the edge faces (4) connect a first perimeter of the first face (2) to a second perimeter of the second face (3), wherein the surface of the circuit board (1) comprises a first location and a second location, wherein the first location and the second location are each coated with an electrically conductive coating,
wherein the button (5) comprises an electrically conductive material (5a), wherein the button (5) is movable towards the circuit board (1), such that the electrically conductive material (5a) contacts both the first location and the second location, thereby creating an electrical contact between the first location and the second location,
**characterized in that**
the first location is located on a first edge face (4a), the second location is located on a second edge face (4b), wherein an angle enclosed between an outward normal vector of the first edge face (4a) and an outward normal vector of the second edge face (4b) is within the range of 0° to 90°, and wherein the button (5) has a complementary profile forming a mating surface with the first edge face (4a) and the second edge face (4b).

2. The system of claim 1, wherein the first edge face (4a) and the second edge face (4b) share a common plane.

3. The system of claim 1 or 2, wherein the system further comprises a button carrier (7), wherein the button carrier (7) is, preferably detachably, mounted on the circuit board (1) and comprises a button guide for guiding the button (5).

4. The system of claim 3, wherein the button carrier (7) and/or the button (5) comprise(s) means for limiting a travel distance of the button (5).

5. The system of claim 3 or 4, wherein the button carrier (7) has a through-hole (7b) which forms the button guide, wherein the shape of the through-hole (7b) substantially matches a cross-section of the button (5).

6. The system of any one of the previous claims, wherein the button (5) comprises a groove (5c) and the electrically conductive material (5a) is located on the mating surface inside the groove (5c), wherein a width of the groove (5c) corresponds essentially to a thickness of the circuit board (1).

7. The system of any one of the previous claims, wherein the first edge face (4a) and the second edge face (4b) smoothly connect the first face (2) of the circuit board to the second face (3) of the circuit board (1).

8. The system of any one of the previous claims, wherein the electrically conductive coating is made of gold, copper, tin, silver, or a combination thereof.

9. The system of any one of the previous claims, wherein the electrically conductive material (5a) is made of graphite, gold, copper, tin, silver, or a combination thereof.

10. The system of any one of the previous claims, wherein the button (5) is made of the electrically conductive material (5a), or wherein the button (5) is at least partially coated with the electrically conductive material (5a).

11. The system of any one of the previous claims, wherein the circuit board (1) further comprises a third location coated with the electrically conductive coating and located on a third edge face, wherein an angle enclosed between an outward normal vector of the first edge face (4a) and an outward normal vector of the third edge face is within the range of 0° to 90°, wherein an angle enclosed between an outward normal vector of the second edge face (4b) and an outward normal vector of the third edge face is within the range of 0° to 90°, and wherein the button (5) has a complementary profile forming a mating surface with the first edge face (4a), the second edge face (4b) and the third edge face, wherein the button (5) comprises an electrically insulating material (5b), which is located along the mating surface of the button (5) such that when the electrically conductive material (5a) contacts the first location and the second location, the electrically insulating material (5b) contacts the third location.

12. The system of any one of the previous claims, wherein the electrically conductive coating is an L-shaped plate (6), wherein a first L-shaped plate (6) coats the first location and extends onto the first face (2) and a second L-shaped plate (6) coats the second location and extends onto the first face (2).

13. Use of the system according to any one of the previous claims in a method for creating an electrical contact between a circuit board (1) and a button (5), the method comprising the following steps:
- providing the system, comprising the circuit board (1) and the movable button (5), according to any one of the previous claims,
- moving the button (5) in a direction orthogonal to a normal vector of the first face (2) of the circuit board towards the circuit board (1), thereby bringing the electrically conductive material (5a) into contact with the first location and the second location, and if applicable, bringing the electrically insulating material (5b) into contact with the third location.
